# FASCICULE DE BREVET EUROPEEN

(11) **EP 3 664 235 B1**
(45) Date de publication et mention de la délivrance du brevet: **07.05.2025**
(21) Numéro de dépôt: 19207761.8
(22) Date de dépôt: 07.11.2019
(51) Int. Cl.: H02B 1/56, H05K 7/20

(54) **SYSTEME DE GESTION DE FLUX D'AIR ADAPTABLE SUR UNE ARMOIRE ELECTRIQUE**
STEUERUNGSSYSTEM EINES LUFTSTROMS MONTIERBAR AUF EINEN SCHALTSCHRANK
SYSTEM FOR MANAGING AIR FLOW THAT CAN BE ADAPTED TO AN ELECTRICAL CABINET

(30) Priorité: 07.12.2018 FR 1872473
(43) Date de publication de la demande: 10.06.2020
(73) Titulaire: Schneider Electric Industries SAS, 92500 Rueil Malmaison (FR)
(72) Inventeur: LINARES, Louis, 38050 Grenoble Cedex 09 (FR); LOPEZ, Josep, 38050 Grenoble Cedex 09 (FR)
(74) Mandataire: Lavoix

(56) Documents cités:
- EP-A1- 3 333 992
- DE-U1- 9 408 362
- JP-A- H10 108 323
- US-A- 6 108 203
- US-A1- 2003 224 717

## Description

La présente invention se rapporte à un système de gestion de flux d'air adaptable sur une enveloppe électrique, telle que par exemple une armoire électrique.

L'invention concerne également une installation électrique comprenant une enveloppe électrique sur laquelle est adapté ledit système de gestion de flux d'air.

### Technique antérieure

La gestion de la température dans l'enceinte d'une enveloppe électrique, telle qu'une armoire électrique ou un coffret électrique, est une question traitée de manière récurrente. Les appareils présents dans l'armoire électrique ont tendance à chauffer et il est donc nécessaire de maintenir la température à l'intérieur de l'armoire sous un certain seuil, au risque sinon de dégrader les appareils. Pour répondre à cette contrainte, il est classique d'utiliser un système de ventilation pour créer un flux d'air à travers le volume de l'armoire électrique en aspirant de l'air présent à l'extérieur et en évacuant l'air chaud présent dans l'armoire vers l'extérieur.

Les systèmes de ventilation connus sont notamment placés sur la paroi supérieure de l'armoire électrique. Ils comprennent une entrée reliée au volume interne de l'armoire pour recevoir un flux d'air sortant, une sortie d'air et un ventilateur placé entre l'entrée et la sortie pour entraîner le flux d'air de l'entrée vers la sortie.

Il est connu que ces solutions de ventilation sont souvent susceptibles de tomber en panne, nécessitant alors l'intervention d'un opérateur pour effectuer les réparations. Or lorsqu'un ventilateur devient défaillant, la température à l'intérieur de l'armoire électrique peut devenir critique, avec un risque non négligeable d'endommager les appareils électriques. La solution la plus sûre est alors de tout stopper pour attendre que le système de ventilation soit réparé. Cependant, un arrêt prolongé n'est souvent pas acceptable, notamment pour des raisons économiques.

JP H10 108323 A divulgue une installation électrique comportant une armoire électrique dans un volume interne de laquelle sont agencés des onduleurs. Chacun des onduleurs comporte des ailettes de refroidissement en saillie sur une face arrière de l'onduleur. L'armoire électrique comporte un boitier de circulation d'air, qui est agencé à l'intérieur de l'armoire électrique en reliant librement l'une à l'autre une unique entrée d'air pour le boitier de circulation d'air, qui est connectée directement au volume interne précité de l'armoire électrique et par laquelle l'air de ce volume interne entre dans le boitier de circulation d'air, et une unique sortie d'air pour le boitier de circulation d'air, qui est connectée directement à un boitier de ventilation placé au sommet de l'armoire électrique. Le boitier de ventilation contient un ventilateur qui entraine l'air dans le boitier de circulation d'air depuis son unique entrée d'air jusqu'à son unique sortie d'air, avant de refouler cet air à l'extérieur du boitier de ventilation via un orifice d'échappement. Le boitier de circulation d'air comprend une goulotte verticale, à l'extrémité axiale inférieure de laquelle une entrée axiale forme l'unique entrée d'air précitée, et une goulotte horizontale, à une première extrémité axiale de laquelle est connectée l'extrémité axiale supérieure de la goulotte verticale et dans la partie courante de laquelle est réalisée l'unique sortie d'air précitée. Les ailettes de refroidissement de chaque onduleur sont enchâssées horizontalement dans la goulotte verticale de manière à être balayées par le flux d'air circulant verticalement de bas en haut dans la goulotte verticale.

DE 94 08 362 U1 divulgue un agencement de ventilation de toit pour une armoire électrique. Cet agencement de ventilation de toit comporte une boite à air horizontale, qui est encastrée dans la partie supérieure de l'armoire électrique, ainsi qu'un ventilateur avant et un ventilateur arrière qui sont respectivement connectés sur deux sorties d'air, respectivement avant et arrière, de la boite à air. La base de la boite à air délimite une entrée d'air centrale qui débouche extérieurement sur un radiateur de refroidissement appartenant à un appareil électrique qui est agencé à l'intérieur de l'armoire électrique. La boite à air loge un dispositif de répartition d'air divisant la boite à air en une chambre d'apaisement d'air, qui communique directement avec l'entrée d'air centrale, et deux conduits, respectivement avant et arrière, qui communiquent directement avec, respectivement, la sortie d'air avant et la sortie d'air arrière. Le dispositif de répartition d'air comporte à la fois un volet avant, qui commande le raccordement entre la chambre d'apaisement d'air et le conduit avant, et un volet arrière, qui commande le raccordement entre la chambre d'apaisement d'air et le conduit arrière.
Le but de l'invention est de proposer un système de gestion de flux d'air qui est adaptable sur une enveloppe électrique, telle qu'une armoire électrique. Ce système présente la particularité de palier les inconvénients de l'état de la technique en permettant de prolonger le fonctionnement de la ventilation à destination de l'enveloppe électrique, en cas de défaillance du ventilateur, ceci sans l'intervention d'un opérateur.

### Exposé de l'invention

Ce but est atteint par un système de gestion de flux d'air tel que défini à la revendication 1.

Des particularités du système sont définies aux revendications 2 à 9.

L'invention concerne également une installation électrique telle que définie à la revendication 10.

Une particularité de cette installation est définie à la revendication 11.

### Brève description des dessins

D'autres caractéristiques et avantages vont apparaître dans la description détaillée qui suit faite en regard des dessins annexés dans lesquels :
[fig.1]

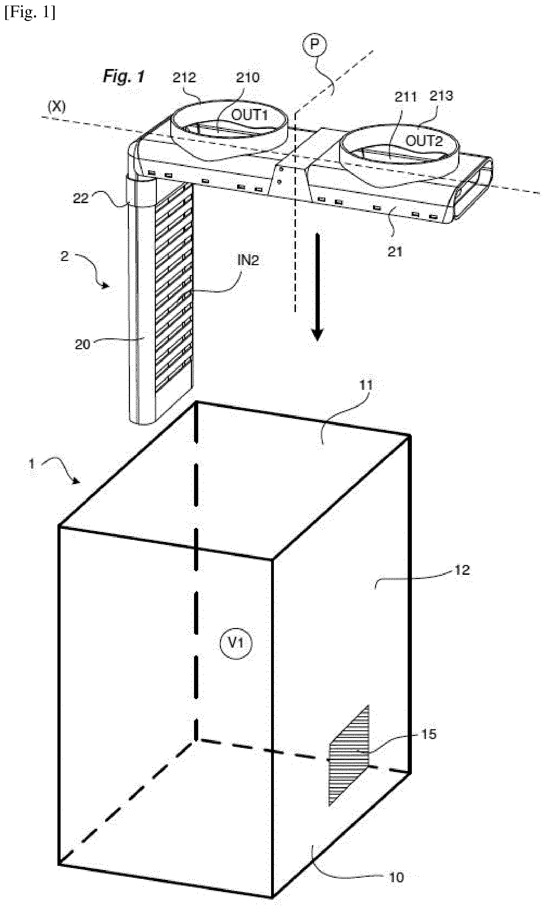

   La figure 1 représente, vu en perspective, le système de gestion de flux d'air de l'invention, adaptable sur une enveloppe électrique.
[fig.2]

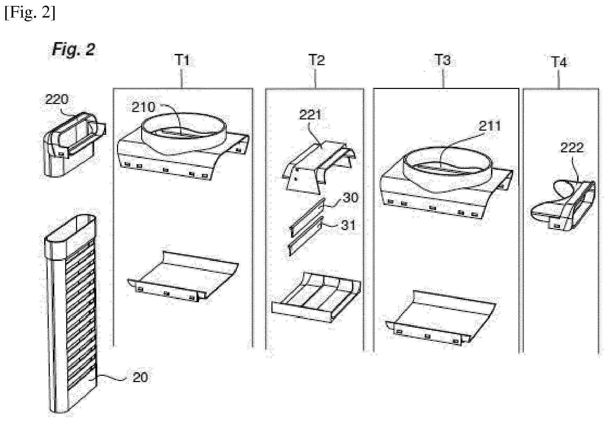

   La figure 2 représente le système de l'invention, vu en éclaté.
[fig.3]

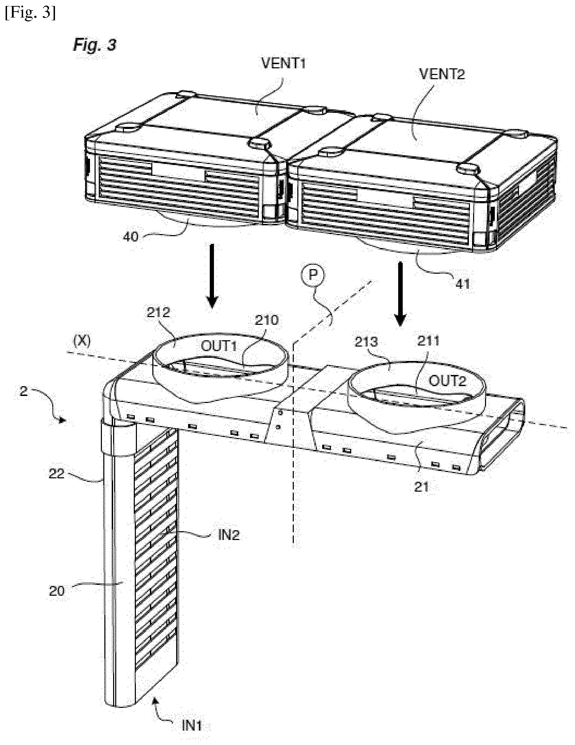

   La figure 3 représente le système de l'invention et un système de ventilation destiné à venir s'adapter sur le système de l'invention.
[fig.4A]
   [fig.4B]

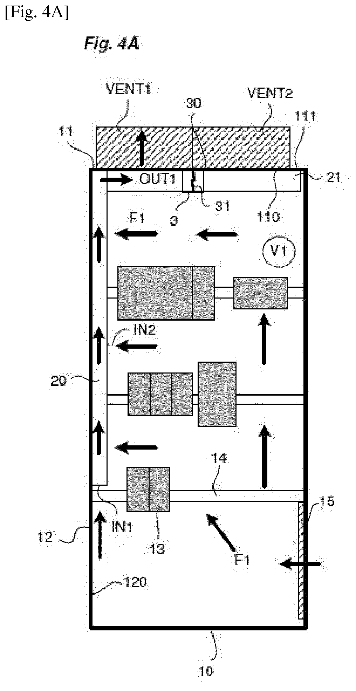

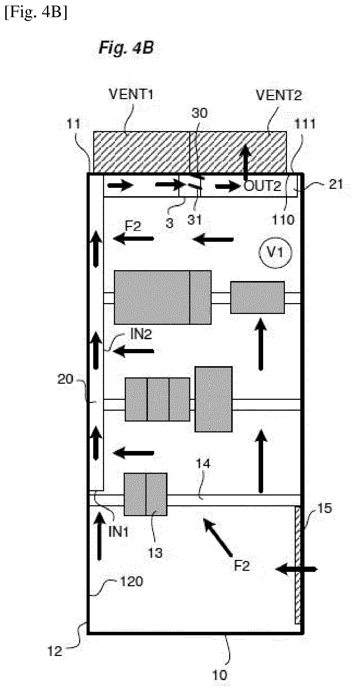

   Les figures 4A et 4B illustrent de manière schématique le principe de fonctionnement du système de de l'invention, respectivement dans ses deux états de fonctionnement.
[fig.5A]
   [fig.5B]

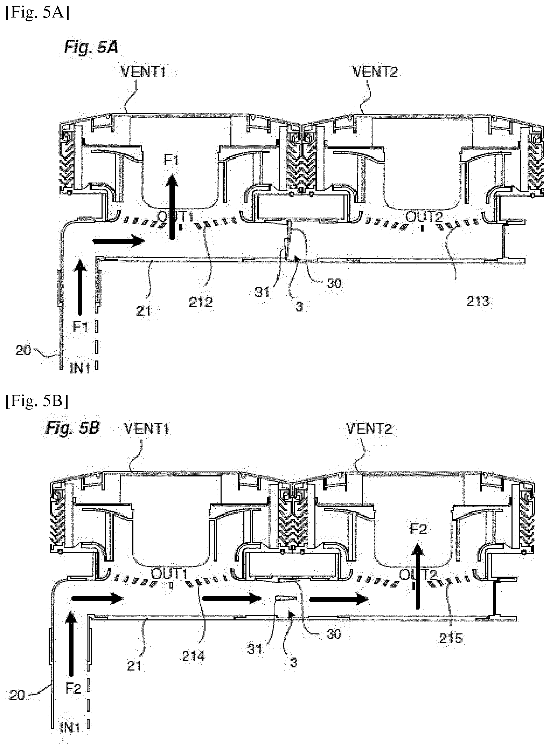

   Les figures 5A et 5B représentent, vu en coupe longitudinale, le système de l'invention, dans ses deux états de fonctionnement.

### Description détaillée d'au moins un mode de réalisation

En référence à la figure 1, le système 2 de gestion de flux d'air de l'invention est adaptable sur une enveloppe électrique. Par enveloppe électrique, on entend une armoire électrique, un coffret électrique ou équivalent. Dans la suite de la description et sur les dessins, on considérera que l'enveloppe électrique est une armoire électrique 1.

Dans la suite de la description, les termes "amont" et "aval" sont à considérer en tenant compte du sens du flux d'air qui circule dans le système.

De manière non limitative, une armoire électrique 1 peut comporter une paroi inférieure 10, une paroi supérieure 11 et quatre parois latérales 12 opposées deux à deux.Ses parois délimitent un premier volume interne V1 dans lequel sont placés des appareils électriques. Dans l'armoire électrique, les appareils électriques 13 peuvent être montés sur des supports, tels que montants et rails 14 adaptés (voir figures 4A et 4B). L'armoire électrique 1 comporte une grille 15 (figures 4A et 4B) permettant à son volume interne d'échanger de l'air avec l'extérieur.

L'armoire électrique 1 pourra être fabriquée dans un matériau métallique.

De manière non limitative mais avantageuse, le système 2 de gestion de flux d'air conforme à l'invention est inséré partiellement ou en totalité dans le volume de l'armoire électrique et peut être fixé à la paroi supérieure 11 de l'armoire électrique, sur la face inférieure 110 de cette paroi supérieure 11. Par ailleurs, les deux ventilateurs du système de ventilation sont positionnés sur la face supérieure 111 de cette paroi supérieure 11.

L'invention vise un système 2 qui permet d'assurer de manière simple une redondance entre au moins deux ventilateurs d'un même système de ventilation associé àune seule armoire électrique. Par redondance, on entend que le système 2 permet au deuxième ventilateur VENT2 de prendre le relais du premier ventilateur VENT1 en cas de défaillance de ce premier ventilateur et ainsi de gérer le flux d'air qui traverse le volume interne de l'armoire électrique.

Le système 2 de l'invention est destiné à venir s'insérer dans le volume V1 de l'armoire électrique en amont du système de ventilation et vient ainsi s'adapter entre l'armoire électrique 1 et le système de ventilation pour permettre la redondance.

Le système de l'invention comporte avantageusement au moins une entrée d'air IN1, IN2 et au moins deux sorties d'air OUT1, OUT2. Dans la suite de la description, on verra que le système 2 peut comporter plusieurs entrées d'air (référencées IN1 et IN2) même si celles-ci ont toutes une fonction équivalente.

Chaque entrée d'air IN1, IN2 est destinée à être en communication avec le volume interne V1 de l'armoire électrique. On peut noter que la grille 15 présente sur l'armoire électrique 1 pourra être placée à l'opposé de chaque entrée d'air IN1, IN2 pour favoriser la circulation du flux d'air dans l'armoire électrique 1.

Un premier ventilateur VENT1 est associé à la première sortie d'air pour générer, lorsqu'il est actif, un premier flux d'air F1 en provenance de chaque entrée d'air IN1, IN2 du système à travers la première sortie d'air OUT1 et un deuxième ventilateur VENT2 est associé à la deuxième sortie d'air pour générer, lorsqu'il est actif, un deuxième flux d'air F2 en provenance de chaque entrée d'air IN1, IN2 du système à travers la deuxième sortie d'air OUT2.

Comme illustré par la figure 2, le système 2 comporte un boîtier 22 monobloc obtenu par l'assemblage de plusieurs éléments entre eux.

Parmi les éléments du boîtier 22, le système 2 comporte une première goulotte 20 sur laquelle est réalisée chaque entrée d'air IN1, IN2. Cette première goulotte 20 du système vient se placer à l'intérieur de l'armoire électrique 1 ou à l'extérieur de l'armoire électrique. De manière avantageuse comme représenté sur les figures annexées, cette goulotte 20 peut comporter une entrée d'air axiale IN1 d'extrémité et plusieurs entrées d'air IN2 latérales sur toute sa longueur, chaque entrée d'air étant mise en communication avec le volume interne V1 de l'armoire électrique 1 pour prélever l'air présent dans l'armoire électrique. Cette goulotte 20 peut être configurée pour longer l'une des parois latérales 12 de l'armoire électrique, à l'intérieur ou à l'extérieur. Si elle est placée à l'extérieur de l'armoire, chacune de ses entrées d'air doit être mise en communication de manière étanche avec le volume interne V1 de l'armoire électrique. Si elle est placée à l'intérieur de l'armoire (comme représenté sur les figures 4A et 4B), elle peut être en appui contre la face interne 120 de la paroi latérale 12 et ses entrées d'air sont placées directement dans le volume interne V1 de l'armoire. On peut noter que le système 2 pourrait comporter plusieurs goulottes d'entrée d'air de ce type, répartis sur les parois latérales 12 de l'armoire électrique 1.

Parmi les éléments du boîtier 22, le système comporte également une deuxième goulotte 21 allongée suivant un axe principal (X) et définissant un canal principal suivant ledit axe, par lequel circule le flux d'air. Cette deuxième goulotte 21 prolonge la première goulotte 20 dans la direction aval. Elle comporte une entrée d'air sur laquelle est connectée la deuxième extrémité de la première goulotte 20, un canal interne et une deuxième extrémité obturée.

Les deux goulottes 20, 21 forment entre elles un angle droit. Ainsi, lorsque le système 2 est adapté sur l'armoire électrique 1, la deuxième goulotte 21 peut être positionnée contre la face inférieure 110 de la paroi supérieure 11 de l'armoire électrique1 et la première goulotte 20 longe la face interne 120 de la paroi latérale 12.

De manière non limitative, les deux goulottes peuvent présenter une section transversale de forme oblongue.

En référence à la figure 2, le boîtier 22 peut comporter des éléments d'assemblage 220, 221, 222 permettant d'assembler ses éléments entre eux. Le boîtier peut comporter un élément coudé 220 permettant d'assembler les deux goulottes 20, 21 entre elles, un élément intermédiaire 221 pour assembler plusieurs éléments formant la deuxième goulotte 21 et un élément terminal 222 permettant d'obturer la deuxième goulotte à son extrémité libre. La deuxième goulotte 21 peut elle-même être réalisée en quatre tronçons, qui sont, en allant de l'amont vers l'aval :
- Un premier tronçon T1 portant la première sortie d'air OUT1,
- Un deuxième tronçon T2 comportant l'élément intermédiaire 221 et portant le dispositif d'aiguillage 3 (voir ci-après),
- Un troisième tronçon T3 portant la deuxième sortie d'air OUT2,
- Un quatrième tronçon T4 comportant l'élément terminal 222.

En outre, chaque tronçon peut être réalisé en deux parties complémentaires assemblables entre elles de part et d'autre de l'axe (X) pour réaliser le canal de la goulotte21.

La deuxième goulotte 21 comporte deux ouvertures 210, 211 latérales (par rapport à l'axe (X)) réalisées de manière traversantes et destinées chacune à être en vis-à-vis d'une ouverture distincte correspondante réalisée à travers la paroi supérieure 11 de l'armoire électrique 1. Chacune des ouvertures 210, 211 définit un siège 212, 213 (figure 3) ou logement pour y connecter un ventilateur VENT1, VENT2 du système de ventilation positionné de l'autre côté de la paroi 11 de l'armoire électrique 1. Pour cela, chaque ventilateur peut comporter un manchon de connexion 40, 41 destiné à traverser la paroi supérieure 11 de l'armoire électrique pour venir s'adapter sur le siège 212, 213 correspondant du système.

Chacune de ces ouvertures 210, 211 peut présenter un bord circulaire. Elles forment chacune l'une des deux sorties d'air OUT1, OUT2 du système 2 et communiquent directement avec le canal de cette deuxième goulotte 21.

La deuxième ouverture 211 est réalisée en aval par rapport à la première ouverture210, en suivant la longueur du canal principal.

Les deux ouvertures 210, 211 sont avantageusement identiques.

Les deux ouvertures 210, 211 sont avantageusement réalisées de manière symétrique par rapport à un plan P transversal à la direction du flux d'air (F1 ou F2) dans la deuxième goulotte, et donc transversal à l'axe principal (X) de la deuxième goulotte 21.

Le système 2 peut comporter une grille 214, 215 de filtrage positionnée en vis-à-vis de chaque ouverture pour filtrer le flux d'air sortant.

Hormis chaque entrée d'air IN1, IN2 et les deux sorties d'air OUT2, OUT2, l'assemblage des éléments du système de l'invention est réalisé de manière hermétique par rapport à l'extérieur.

Selon une particularité, les deux sorties d'air OUT1, OUT2 sont arrangées en parallèle sur le canal principal du système.

Le système de l'invention comporte également un dispositif d'aiguillage 3 du flux d'air entrant dans le système.

Ce dispositif d'aiguillage 3 est agencé à l'intérieur de la deuxième goulotte 21 et vient s'intercaler entre la première sortie d'air OUT1 et la deuxième sortie d'air OUT2.

Ce dispositif d'aiguillage comporte un ou plusieurs volets mobiles. A titre d'exempleet de manière non limitative, sur les figures annexées, deux volets mobiles 30, 31 sont représentés.

Chaque volet mobile 30, 31 est monté en pivotement autour d'un axe. Les axes de pivotement de tous les volets sont parallèles entre eux et orientés parallèlement audit plan transversal P.

Les deux volets mobiles 30, 31 sont par exemple superposés pour s'étendre sur toute la section transversale d'écoulement du flux d'air à l'intérieur de la goulotte.

Les deux volets mobiles 30, 31 sont avantageusement commandés simultanément.

De manière avantageuse, les deux volets mobiles 30, 31 peuvent être commandés par la seule pression du flux d'air circulant dans la deuxième goulotte suivant l'axe (X).

Les deux volets mobiles 30, 31 sont aptes à prendre une première position dite fermée dans laquelle ils obturent la liaison entre chaque entrée d'air IN1, IN2 et la deuxième sortie d'air OUT2 (figures 4A et 5A) et une deuxième position dite ouverte, dans laquelle ils autorisent la liaison entre chaque entrée d'air IN1, IN2 et la deuxième sortie d'air OUT2 (figures 4B et 5B).

Pour aller de leur première position à leur deuxième position, les volets mobiles 30, 31 peuvent être montés pivotant suivant un seul sens de rotation, correspondant au sens défini par le flux d'air F2 dans la goulotte lorsque le deuxième ventilateur VENT2 est actif.

Pour aller de leur première position vers leur deuxième position, les volets mobiles 30, 31 pivotent ainsi suivant un premier sens de rotation (par exemple le sens inverse des aiguilles d'une montre) puis pour revenir à leur première position, ils pivotent suivant un deuxième sens de rotation (qui correspond au sens des aiguilles d'une montre).

De manière non limitative, les volets mobiles 30, 31 peuvent être montés chacun sur un ressort. La pression de chaque ressort peut être réglée pour autoriser le pivotement du volet lorsqu'une pression d'air minimale est appliquée. Le flux d'air F2 généré par le deuxième ventilateur VENT2 uniquement doit être suffisant pour produire une pression supérieure à ladite pression minimale nécessaire au pivotement.

Selon un mode de réalisation particulier, il serait possible de prévoir des réglages de pivotement différents entre les deux volets mobiles 30, 31, par réglage de la force de leur ressort. Le premier volet mobile 30 serait d'abord autorisé à pivoter lorsqu'un premier niveau de pression de flux d'air est dépassé et le deuxième volet mobile 31 serait ensuite autorisé à pivoter, en complément du premier volet, lorsqu'un deuxième niveau de pression est dépassé, ce deuxième niveau de pression étant supérieur au premier niveau de pression. Cette solution permettrait de régler facilement le débit d'air sortant par chacune des deux sorties d'air.

En référence aux figures 4A, 5A et 4B, 5B, le fonctionnement du système de l'invention est ainsi le suivant :
- Figure 4A et figure 5A - Premier état de fonctionnement : Le premier ventilateur VENT1 est en fonctionnement et le deuxième ventilateur VENT2 estarrêté. Le flux d'air F1 prélevé à l'intérieur de l'armoire électrique, pénètre dans le système par chaque entrée d'air IN1, IN2, passe dans la première goulotte 20 pour rejoindre la deuxième goulotte 21. Le premier ventilateur VENT1 étant en fonctionnement, le flux d'air F1 est entraîné vers la première sortie d'air OUT1 du système et s'échappe vers l'extérieur via la première sortie d'air et le premier ventilateur. Le deuxième ventilateur VENT2 étant à l'arrêt, aucun flux d'air ne vient pousser les volets mobiles 30, 31, ceux-ci restant alors dans leur position fermée.
- Figure 4B et figure 5B - Deuxième état de fonctionnement : Le premier ventilateur VENT1 est à l'arrêt (il est par exemple en panne ou en maintenance...). Le deuxième ventilateur VENT2 est activé. Le flux d'air F2 prélevé dans le volume V1 de l'armoire électrique 1, pénètre dans le système 2 par chaque entrée d'air IN1, IN2, passe dans la première goulotte 20 pour rejoindre la deuxième goulotte 21. Le premier ventilateur VENT1 étant à l'arrêt et le deuxième ventilateur VENT2 en fonctionnement, le flux d'air F2 se dirige vers la deuxième sortie d'air OUT2. Le flux d'air F2 applique une pression sur les volets mobiles 30, 31 et les pousse pour les faire pivoter. Le flux d'air F2 traverse ainsi l'ouverture créée grâce au pivotement des volets et gagne la deuxième sortie d'air OUT2 pour être évacué vers l'extérieur grâce au deuxième ventilateur VENT2.

On peut noter que la détection de l'arrêt du premier ventilateur VENT1 et l'activationdu deuxième ventilateur VENT2 peuvent être effectués par tous moyens, de type automatiques et/ou manuels.

Il est également possible de prévoir dans le système, pour chaque volet mobile 30, 31, un capteur de position relié à une unité centrale de commande et destiné à détecter la position ouverte ou fermée de chaque volet et ainsi à s'assurer de leur bon fonctionnement. Le capteur de position peut être un capteur mécanique de type fin de course.

L'activation simultanée des deux ventilateurs VENT1, VENT2 peut également être prévue, par exemple pour permettre à l'un des deux ventilateurs de fonctionner en mode ralenti, ou pour générer un flux d'air plus conséquent dans l'armoire électrique 1. Dans cette situation, le pivotement des volets mobiles 30, 31 doit être réglé pour laisser une partie du flux d'air rejoindre également la deuxième sortie d'air OUT1, en plus de la première sortie d'air OUT1.

La solution de l'invention présente ainsi de nombreux avantages, parmi lesquels :
- Une solution simple pour mettre en œuvre une redondance entre les deux ventilateurs ;
- Une solution fiable car ne nécessitant aucune commande particulière, les volets mobiles se déplaçant grâce à la pression du flux d'air ;
- Une solution facilement adaptable sur une armoire existante, celle-ci étant indépendante de l'architecture de l'armoire électrique ;
- Une solution permettant d'assurer une continuité de service, même en cas de défaillance partielle du système de ventilation.

## Revendications

1. Système (2) de gestion de flux d'air adaptable sur une enveloppe électrique qui comporte plusieurs parois qui délimitent un volume interne (V1) destiné à loger des appareils électriques (13), lequel système (2) comporte :
- Un boîtier (22) ayant une ou plusieurs entrées d'air (IN1, IN2), destinées à être mises en communication avec le volume interne (V1) de l'enveloppe électrique, et des première et deuxième sorties d'air (OUT1, OUT2), lequel boîtier (22) comporte :
• une goulotte principale (21) agencée pour relier la ou les entrées d'air (IN1, IN2) aux première et deuxième sorties d'air (OUT1, OUT2), laquelle goulotte principale (21) :
• est allongée suivant un axe principal (X),
• définit suivant l'axe principal (X) un unique canal de transport de flux d'air, par lequel la ou les entrées d'air (IN1, IN2) sont reliées à la première sortie d'air (OUT1) et à la deuxième sortie d'air (OUT2),
• comporte une première ouverture (210), qui forme la première sortie d'air (OUT1) et qui communique directement avec le canal de transport, la première ouverture étant en aval d'une entrée de la goulotte principale (21) suivant l'axe principal (X), et
• comporte une deuxième ouverture (211), qui forme la deuxième sortie d'air (OUT2) et qui communique directement avec le canal de transport, la deuxième ouverture étant en aval de la première ouverture (210) suivant l'axe principal (X), et
• une goulotte d'entrée (20) qui :
• est connectée sur la goulotte principale (21) de manière que la goulotte principale et la goulotte d'entrée forment entre elles un angle droit et que la goulotte principale prolonge la goulotte d'entrée dans la direction aval,
• comporte une première extrémité sur laquelle est réalisée une entrée d'air axiale (IN1) qui forme la ou une des entrées d'air (IN1, IN2), et
• comporte une deuxième extrémité qui est connectée sur l'entrée de la goulotte principale (21), et
- Un dispositif d'aiguillage (3) agencé à l'intérieur de ladite goulotte principale (21), entre la première sortie d'air (OUT1) et la deuxième sortie d'air (OUT2), ledit dispositif d'aiguillage comportant au moins un volet mobile (30, 31) commandable entre une première position, dans laquelle la ou les entrées d'air (IN1, IN2) communiquent uniquement avec la première sortie d'air via la goulotte d'entrée (20) et la goulotte principale (21), et une deuxième position, dans laquelle la ou les entrées d'air communiquent au moins avec la deuxième sortie d'air via la goulotte d'entrée (20) et la goulotte principale (21).

2. Système selon la revendication 1, dans lequel les première et deuxième ouvertures (210, 211) sont réalisées de manière symétrique par rapport à un plan (P) transversal à l'axe principal (X).

3. Système selon l'une des revendications 1 ou 2, dans lequel ledit volet mobile (30, 31) est intercalé dans ledit canal de transport entre la première sortie d'air (OUT1) et la deuxième sortie d'air (OUT2).

4. Système selon la revendication 3, dans lequel ledit volet mobile (30, 31) est monté libre en pivotement entre ladite première position et ladite deuxième position.

5. Système selon la revendication 4, dans lequel le volet mobile est monté libre en pivotement pour pivoter dans un seul sens, de ladite première position vers ladite deuxième position, sous la seule pression du flux d'air (F2) circulant dans ledit canal de transport.

6. Système selon l'une des revendications précédentes, dans lequel ledit boîtier (22) comporte un premier logement agencé pour recevoir un premier ventilateur (VENT1) et un deuxième logement agencé pour recevoir un deuxième ventilateur (VENT2), ledit premier logement comprenant ladite première ouverture (210) et ledit deuxième logement comportant ladite deuxième ouverture (211).

7. Système selon la revendication 6, dans lequel le système (2) comporte une grille (214, 215) placée dans chaque logement et agencée entre la sortie d'air correspondante et ledit canal de transport.

8. Système selon l'une des revendications précédentes, dans lequel la goulotte principale (21) et la goulotte d'entrée (20) présentent une section transversale de forme oblongue.

9. Système selon l'une des revendications précédentes, dans lequel la goulotte d'entrée (20) comporte plusieurs ouvertures latérales, formant chacuneune des entrées d'air (IN2) distinctes du système.

10. Installation électrique comportant :
- Une enveloppe électrique qui comprend une paroi inférieure (10), une paroi supérieure (11) et au moins une paroi latérale (12), de manière à délimiter un premier volumeinterne (V1) recevant des appareils électriques (13),
- Un système (2), qui est tel que défini dans l'une des revendications 1 à 9 et qui est installé sur l'une des parois de l'enveloppe électrique, la ou les entrées d'air (IN1, IN2) étant connectées audit volume interne (V1) de l'armoire électrique, et
- Un système de ventilation comprenant un premier ventilateur (VENT1) connecté sur la première sortie d'air (OUT1) et undeuxième ventilateur (VENT2) connecté sur la deuxième sortie d'air (OUT2).

11. Installation électrique selon la revendication 10, dans laquelle l'enveloppe électrique comporte une grille (15) placée devant une ouverture réalisée à travers l'une de ses parois.

## Patentansprüche

1. System (2) zur Steuerung des Luftstroms, das an eine elektrische Hülle anpassbar ist, die mehrere Wände umfasst, die ein Innenvolumen (V1) begrenzen, das dazu bestimmt ist, elektrische Geräte (13) aufzunehmen, wobei das System (2) Folgendes umfasst:
- Ein Gehäuse (22), das einen oder mehrere Lufteinlässe (IN1, IN2) aufweist, die dazu bestimmt sind, mit dem Innenvolumen (V1) des elektrischen Gehäuses in Verbindung gebracht zu werden, und einen ersten und einen zweiten Luftauslass (OUT1, OUT2), wobei das Gehäuse (22) Folgendes umfasst:
• einen Hauptkanal (21), der angeordnet ist, um den einen oder die mehreren Lufteinlässe (IN1, IN2) mit dem ersten und dem zweiten Luftauslass (OUT1, OUT2) zu verbinden, wobei der Hauptkanal (21):
• entlang einer Hauptachse (X) langgestreckt ist,
• entlang der Hauptachse (X) einen einzelnen Luftstromtransportkanal definiert, durch den der Lufteinlass oder die Lufteinlässe (IN1, IN2) mit dem ersten Luftauslass (OUT1) und dem zweiten Luftauslass (OUT2) verbunden sind,
• eine erste Öffnung (210) umfasst, die den ersten Luftauslass (OUT1) bildet und direkt mit dem Transportkanal in Verbindung ist, wobei die erste Öffnung entlang der Hauptachse (X) stromabwärts von einem Eingang des Hauptkanals (21) ist, und
• eine zweite Öffnung (211) aufweist, die den zweiten Luftauslass (OUT2) bildet und direkt mit dem Transportkanal in Verbindung ist, wobei die zweite Öffnung entlang der Hauptachse (X) stromabwärts von der ersten Öffnung (210) ist, und
• einen Eingangskanal (20), der:
• mit dem Hauptkanal (21) verbunden ist, sodass der Hauptkanal und der Einlasskanal einen rechten Winkel zueinander bilden und der Hauptkanal den Einlasskanal in stromabwärtiger Richtung verlängert,
• ein erstes Ende umfasst, an dem ein axialer Lufteinlass (IN1) ausgeführt ist, der den oder einen der Lufteinlässe (IN1, IN2) bildet, und
• ein zweites Ende umfasst, das mit dem Eingang des Hauptkanals (21) verbunden ist, und
- Eine Abzweigvorrichtung (3), die innerhalb des Hauptkanals (21) zwischen dem ersten Luftauslass (OUT1) und dem zweiten Luftauslass (OUT2) angeordnet ist, wobei die Abzweigvorrichtung mindestens eine bewegliche Klappe (30, 31) umfasst, die zwischen einer ersten Position, in der der oder die Lufteinlässe (IN1, IN2) nur mit dem ersten Luftauslass über den Einlasskanal (20) und den Hauptkanal (21) in Verbindung sind, und einer zweiten Position, in der der oder die Lufteinlässe mindestens mit dem zweiten Luftauslass über den Einlasskanal (20) und den Hauptkanal (21) in Verbindung sind, steuerbar ist.

2. System nach Anspruch 1, wobei die erste und die zweite Öffnung (210, 211) symmetrisch zu einer Ebene (P) quer zu der Hauptachse (X) ausgeführt sind.

3. System nach einem der Ansprüche 1 oder 2, wobei die bewegliche Klappe (30, 31) in den Transportkanal zwischen dem ersten Luftauslass (OUT1) und dem zweiten Luftauslass (OUT2) eingefügt ist.

4. System nach Anspruch 3, wobei die bewegliche Klappe (30, 31) frei schwenkend zwischen der ersten Position und der zweiten Position montiert ist.

5. System nach Anspruch 4, wobei die bewegliche Klappe frei schwenkend montiert ist, um nur unter dem Druck des Luftstroms (F2), der in dem Transportkanal strömt, in einer einzigen Richtung von der ersten Position in die zweite Position zu schwenken.

6. System nach einem der vorherigen Ansprüche, wobei das Gehäuse (22) eine erste Aufnahme, die zum Aufnehmen eines ersten Ventilators (VENT1) angeordnet ist, und eine zweite Aufnahme, die zum Aufnehmen eines zweiten Ventilators (VENT2) angeordnet ist, umfasst, das erste Gehäuse umfassend die erste Öffnung (210) und das zweite Gehäuse umfassend die zweite Öffnung (211).

7. System nach Anspruch 6, wobei das System (2) ein Gitter (214, 215) umfasst, das in jeder Aufnahme platziert und zwischen dem entsprechenden Luftauslass und dem Transportkanal angeordnet ist.

8. System nach einem der vorherigen Ansprüche, wobei der Hauptkanal (21) und der Einlasskanal (20) einen länglichen Querschnitt aufweisen.

9. System nach einem der vorherigen Ansprüche, wobei der Einlasskanal (20) mehrere seitliche Öffnungen umfasst, die jeweils einen der separaten Lufteinlässe (IN2) des Systems bilden.

10. Elektrische Anlage umfassend:
- Eine elektrische Hülle, die eine untere Wand (10), eine obere Wand (11) und mindestens eine Seitenwand (12) umfasst, sodass ein erstes Innenvolumen (V1) abgegrenzt wird, das elektrische Geräte (13) aufnimmt,
- Ein System (2), das wie in einem der Ansprüche 1 bis 9 definiert ist und das an einer der Wände der elektrischen Hülle installiert ist, wobei der Lufteinlass oder die Lufteinlässe (IN1, IN2) mit dem Innenvolumen (V1) des Schaltschranks verbunden sind, und
- Ein Belüftungssystem, umfassend einen ersten Ventilator (VENT1), der mit dem ersten Luftauslass (OUT1) verbunden ist, und einen zweiten Ventilator (VENT2), der mit dem zweiten Luftauslass (OUT2) verbunden ist.

11. Elektrische Anlage nach Anspruch 10, wobei die elektrische Hülle ein Gitter (15) umfasst, das vor einer Öffnung platziert ist, die durch eine ihrer Wände ausgeführt ist.

## Claims

1. An airflow management system (2) adaptable to an electrical enclosure which comprises a plurality of walls which define an internal volume (V1) intended to house electrical units (13), which system (2) comprises:
- a housing (22) having one or more air inlets (IN1, IN2), intended to be placed in communication with the internal volume (V1) of the electrical enclosure, and first and second air outlets (OUT1, OUT2), which housing (22) comprises:
• a main duct (21) arranged to connect the air inlet(s) (IN1, IN2) to the first and second air outlets (OUT1, OUT2), which main duct (21):
• is elongated along a main axis (X),
• defines along the main axis (X) a single airflow transport channel, via which the air inlet(s) (IN1, IN2) are connected to the first air outlet (OUT1) and to the second air outlet (OUT2),
• comprise a first opening (210), which forms the first air outlet (OUT1) and communicates directly with the transport channel, the first opening being downstream of an inlet to the main duct (21) along the main axis (X), and
• comprises a second opening (211), which forms the second air outlet (OUT2) and communicates directly with the transport channel, the second opening being downstream of the first opening (210) along the main axis (X), and
• an inlet duct (20) which:
• is connected to the main duct (21) so that the main duct and the inlet duct form a right angle with each other and the main duct extends the inlet duct in the downstream direction,
• comprises a first end at which an axial air inlet (IN1) is produced, which forms the or one of the air inlets (IN1, IN2), and
• comprises a second end which is connected to the inlet of the main duct (21), and
- a diverter device (3) arranged inside said main duct (21), between the first air outlet (OUT1) and the second air outlet (OUT2), said diverter device comprising at least one movable flap (30, 31) controllable between a first position in which the air inlet(s) (IN1, IN2) communicate only with the first air outlet via the inlet duct (20) and the main duct (21), and a second position in which the air inlet(s) communicate at least with the second air outlet via the inlet duct (20) and the main duct (21).

2. The system according to claim 1, wherein the first and second openings (210, 211) are symmetrical with respect to a plane (P) transverse to the main axis (X).

3. The system according to one of claims 1 or 2, wherein said movable flap (30, 31) is interposed in said transport channel between the first air outlet (OUT1) and the second air outlet (OUT2).

4. The system according to claim 3, wherein said movable flap (30, 31) is mounted so as to pivot freely between said first position and said second position.

5. The system according to claim 4, wherein the movable flap is mounted so as to pivot freely in one direction only, from said first position to said second position, solely under the pressure of the airflow (F2) circulating within said transport channel.

6. The system according to one of the preceding claims, wherein said housing (22) comprises a first recess arranged to receive a first fan (VENT1) and a second recess arranged to receive a second fan (VENT2), said first recess comprising said first opening (210) and said second recess comprising said second opening (211).

7. The system according to claim 6, wherein the system (2) comprises a grille (214, 215) placed in each housing and arranged between the corresponding air outlet and said transport channel.

8. The system according to one of the preceding claims, wherein the main duct (21) and the inlet duct (20) have an oblong cross-section.

9. The system according to one of the preceding claims, wherein the inlet duct (20) has several lateral openings, each forming one of the separate air inlets (IN2) of the system.

10. An electrical installation, comprising:
- an electrical enclosure comprising a bottom wall (10), a top wall (11) and at least one side wall (12), so as to delimit a first internal volume (V1) housing electrical units (13),
- a system (2), which is as defined in one of claims 1 to 9 and which is installed on one of the walls of the electrical enclosure, the air inlet(s) (IN1, IN2) being connected to said internal volume (V1) of the electrical enclosure, and
- a ventilation system comprising a first fan (VENT1) connected to the first air outlet (OUT1) and a second fan (VENT2) connected to the second air outlet (OUT2).

11. The electrical installation according to claim 10, wherein the electrical enclosure comprises a grille (15) placed in front of an opening made through one of its walls.
